# EUROPÄISCHE PATENTANMELDUNG

(11) **EP 0 671 815 A1**
(43) Veröffentlichungstag der Anmeldung: **13.09.1995**
(21) Anmeldenummer: 95103392.7
(22) Anmeldetag: 09.03.1995
(51) Int. Cl.: H03M 1/06, H03M 1/66

(54) **Verfahren zur Linearisierung von Unstetigkeiten in der Übertragungskennlinie eines D/A-Wandlers sowie Anordnung und Anwendung**

(30) Priorität: 11.03.1994 DE 4408181
(71) Anmelder: ROBERT BOSCH GMBH, 70442 Stuttgart (DE)
(72) Erfinder: Grotz, Karlheinz, D-70734 Fellbach (DE); Mayer, Jörg, D-70374 Stuttgart (DE)

(57) **Zusammenfassung**

Zur Linearisierung von Unstetigkeiten in der Übertragungskennlinie eines D/A-Wandlers (DACl) erfolgt ein Abgleich des D/A-Wandlers derart, daß sich nur negative differentielle Unstetigkeiten (U1, U2, ... Un) ergeben. Die Amplitudenwerte dieser Unstetigkeiten werden dem Eingangssignal des D/A-Wandlers mit inversem Vorzeichen zugesetzt.

Toleranzen der gewichteten Stromquellen eines D/A-Wandlers insbesondere beim Umschalten, d.h. Wechsel des Quantisierungsbereiches, führen bei Anwendung der Maßnahmen der Erfindung nicht zu Fehlern.

Ein solcher D/A-Wandler eignet sich insbesondere zur Verarbeitung von Signalen mit hoher Abtastfrequenz und hoher Auflösung, z.B. für digitale Videosignale, die zu Frequenz-Kanalbündeln zusammengefaßt sind.

## Beschreibung

Die Erfindung geht aus von einem Verfahren zur Linearisierung von Unstetigkeiten in der Übertragungskennlinie eines D/A-Wandlers.

Handelsübliche D/A-Wandler weisen architekturbedingte differentielle Unstetigkeiten in ihrer Übertragungskennlinie auf. Bei einem D/A-Wandler gemäß IEEE 13th Annual GaAsIC Symposium, Technical Digest 1991, Monterey, CA, USA, Seiten 361-364, "A 14-Bit, 1 Gs/s DAC for Direct Digital Synthesis Applications", Frederick G. Weiss, Tyler G. Bowman werden die vier höchstwertigsten Bits in einen Thermometercode umgewandelt. Die niederwertigsten Bits werden uncodiert zur Quantisierung von Quantisierungssegmenten benutzt. Zur Verbesserung der Linearität des D/A-Wandlers wird aus allen gewichteten Stromquellen ein Summensignal ermittelt, das in alle gewichteten Stromquellen gleichzeitig eingespeist wird. Differentielle Unstetigkeiten in der Übertragungskennlinie, die durch unterschiedlich hohe Ströme bei den Bereichswechseln des Thermometercodes auftreten, lassen sich auf diese Weise nicht kompensieren. Auch können sich weitere Fehler durch Laufzeiten ergeben.

Aus der WO 90/14717 A1 ist ein D/A-Wandler mit hoher Linearität bekannt. Fehler infolge von Toleranzen beim Quantisierungsbereichswechsel werden dort durch Einprägung fest vorgegebener Umschaltschwellen vermindert. Diese Lösung setzt jedoch mindestens zwei D/A-Wandler mit unterschiedlicher Auflösung voraus. Auch muß hierzu das Wandlerausgangssignal ausgewertet werden, welches verfälscht sein kann, so daß diese Kompensation nicht immer fehlerfrei arbeitet.

Ein Linearisierungsverfahren, das ebenfalls zwei D/A-Wandler voraussetzt und die Reaktion dieser Wandler auf eine Zufallssequenz beobachtet, ist aus der EP 430 449 A2 bekannt.

Aufgabe vorliegender Erfindung ist es, ein Verfahren zur Linearisierung insbesondere von Unstetigkeiten in der Übertragungskennlinie eines D/A-Wandlers anzugeben, bei dem sich Toleranzen von gewichteten Stromquellen des D/A-Wandlers nicht nachteilig auswirken. Außerdem soll eine Anordnung und eine Anwendung für einen solcherart linearisierten D/A-Wandler angegeben werden. Diese Aufgabe wird bezüglich des Verfahrens durch die Schritte des Anspruchs 1, bezüglich der Anordnung durch die Merkmale des Anspruchs 9 und bezüglich der Anwendung durch die Merkmale des Anspruchs 13 gelöst. Die weiteren Ansprüche zeigen Ausgestaltungen des Verfahrens bzw. der Anordnung auf.

Das Verfahren nach der Erfindung setzt für die Linearisierung prinzipiell nur einen D/A-Wandler voraus. Eine Signalrückkopplung, wie etwa bei den Lösungen gemäß EP 447 833 A2 oder WO 90/14717 A1, die bei sehr schnellen D/A-Wandlern wegen Laufzeitproblemen oft nicht brauchbar ist, ist nicht erforderlich. Das Wandlereingangssignal kann auf einfache Weise als Adreßsignal zur Aktivierung abgespeicherter Werte verwendet werden. Toleranzen der gewichteten Stromquellen eines D/A-Wandlers werden individuell durch jeweils einen abgespeicherten Korrekturwert ausgeglichen. Abgleichprobleme durch gegenseitige Abhängigkeiten treten daher nicht auf. Gegenüber den Lösungen mit Differenzauswertung und Signalrückkopplung treten keine Gleichlaufprobleme nichtkompensierbare Temperatureffekte oder Betriebsunterbrechungen auf (40 03 682 A1; WO 90 14 717 A1). Bei der Erfindung ist für die Auswertung differentieller Unstetigkeiten nur eines D/A-Wandlers notwendig. Diese ermittelten Unstetigkeiten werden direkt in den Speicher eingeschrieben. Die Speicherwerte werden dann nur in Abhängigkeit des zu wandelnden Eingangssignals ausgelesen. Ein Nachabgleich wie etwa bei der DE 40 03 682 A1 ist nicht notwendig. Auch ergibt sich kein durch die Signalrückkopplung bedingter Taktverzug.

Das Verfahren / die Anordnung gemäß der Erfindung läßt sich problemlos auch beim Parallelbetrieb mehrerer Wandler zur Auflösungserhöhung einsetzen. Es ist auch möglich, systematische Fehler, z.B. Glitches, durch einfache Verknüpfungsstufen in jedem Parallelzweig zusätzlich zu unterdrücken. Alle diese Maßnahmen tragen dazu bei, handelsübliche D/A-Wandler für extrem hohe Anforderungen zu verbessern, wie z.B. zur Verarbeitung von Video- bzw. Fernsehsignal-Frequenzmultiplexbündeln mit Abtastfrequenzen im Gigahertzbereich, wie z.B. gemäß der DE 41 36 112 A1 oder der DE 40 08 201 C2.

Anhand der Zeichnungen werden nun Ausführungsbeispiele der Erfindung näher erläutert. Es zeigen
Fig. 1 ein Blockschaltbild einer Anordnung gemäß der Erfindung,
Fig. 2 eine Übertragungskennlinie eines D/A-Wandlers ohne die Maßnahmen der Erfindung,
Fig. 3 eine Übertragungskennlinie eines D/A-Wandlers mit den Maßnahmen der Erfindung,
Fig. 4 ein digitalisiertes Sinussignal nach der D/A-Wandlung ohne die Maßnahmen der Erfindung,
Fig. 5 ein digitalisiertes Sinussignal nach der D/A-Wandlung mit den Maßnahmen nach der Erfindung,
Fig. 6 die Amplituden von Unstetigkeiten in der Übertragungskennlinie,
Fig. 7 und Fig. 8 die zu den Figuren 4 und 5 gehörigen Signalspektren,
Fig. 9 ein Blockschaltbild für einen D/A-Wandler nach der Erfindung mit zusätzlicher Unterdrückung systematischer Fehler,
Fig. 10 Ausgangssignale von parallel arbeitenden D/A-Wandlerstufen mit gegeneinander versetzten Offsetsignalen,
Fig. 11 das Ausgangssignal des D/A-Wandlers mit reduzierter systematischer Fehlerspannung (Glitch).

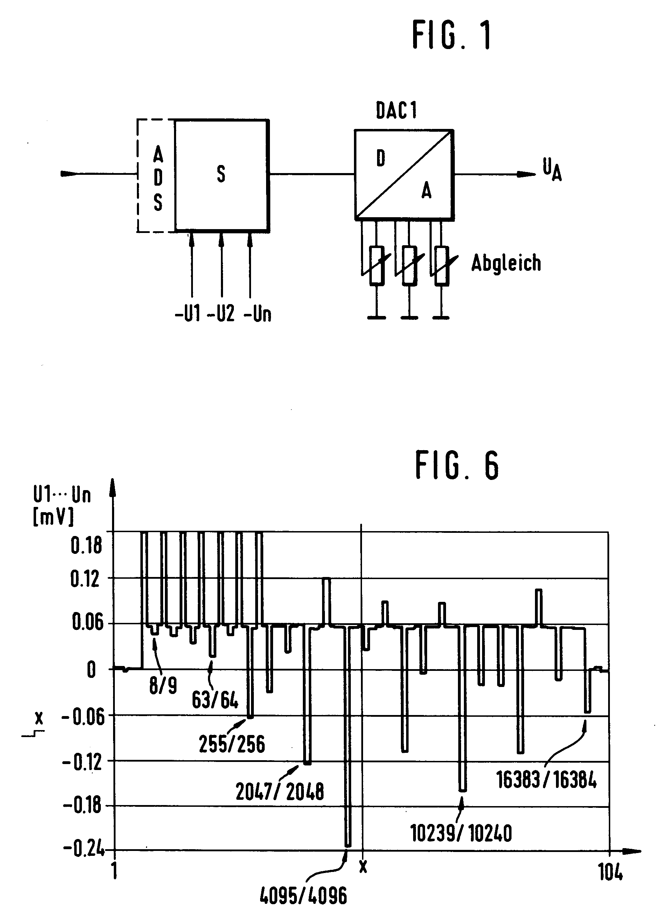

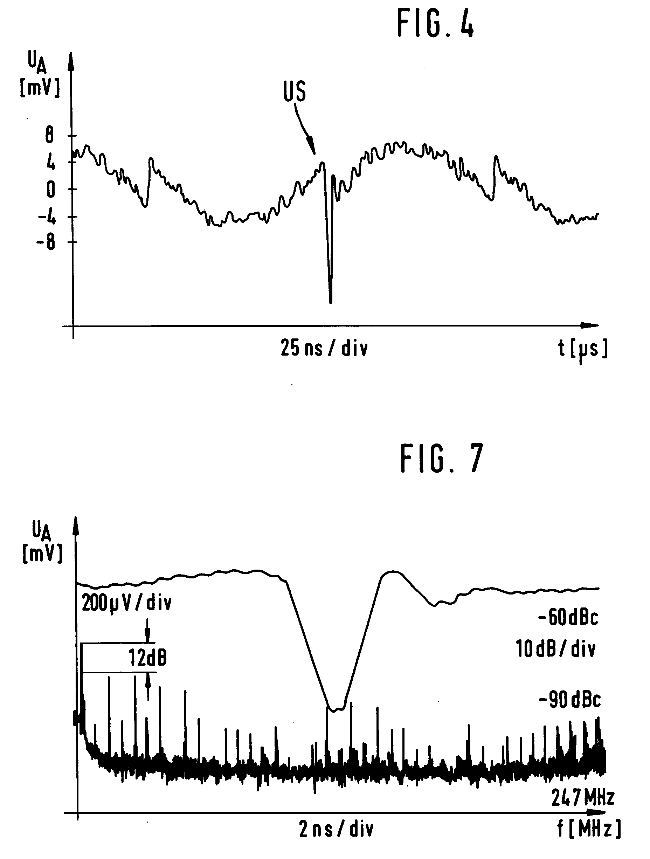

Bei der Anordnung gemäß Fig. 1 wird ein eingangsseitiges zu wandelndes Digitalsignal, z.B. ein digitalisiertes Sinussignal von 6 MHz mit einer Abtastfrequenz von 452 MHz und ± 8 LSB Aussteuerung einem D/A-Wandler DAC1 zugeführt. Fig. 4 zeigt das Ausgangssignal U_{A} eines handelsüblichen D/A-Wandlers, welches mit einem solchen Eingangssignal beaufschlagt ist. Durch eine Unstetigkeit US in der Kennlinie des D/A-Wandlers, die insbesondere durch Toleranzen in den gewichteten Stromquellen des D/A-Wandlers hervorgerufen wird, werden die Halbwellen des Sinussignals stark gegeneinander verschoben, so daß ein starkes Oberwellenspektrum entsteht.
Fig. 7 zeigt das Signalspektrum an dieser Unstetigkeitsstelle zusammen mit der gemessenen Ausgangsspannung U_{A}, jedoch mit höherer zeitlicher Auflösung (2 ns / Zeitmaßstab gegenüber 25 ns / Zeitmaßstab in Fig. 4). Wie aus dem Signalspektrum ersichtlich ist, beginnen die Oberwellen bei ca. 12 dB unter dem Nutzsignal (4 mV / div Amplitudeneinteilung). Um diese Verfälschungen des Eingangssignal durch den D/A-Wandler zu vermindern, werden beim Verfahren der Erfindung insbesondere folgende Maßnahmen getroffen:
Der D/A-Wandler wird so abgeglichen, z.B. durch Zuführen von externen Spannungen über extern zugängliche Abgleichpunkte, daß sich nur negative differentielle Unstetigkeiten U1, U2, ... Un in der Übertragungskennlinie (Ausgangsspannung zu eingangsseitigen Digitalwerten) ergeben.

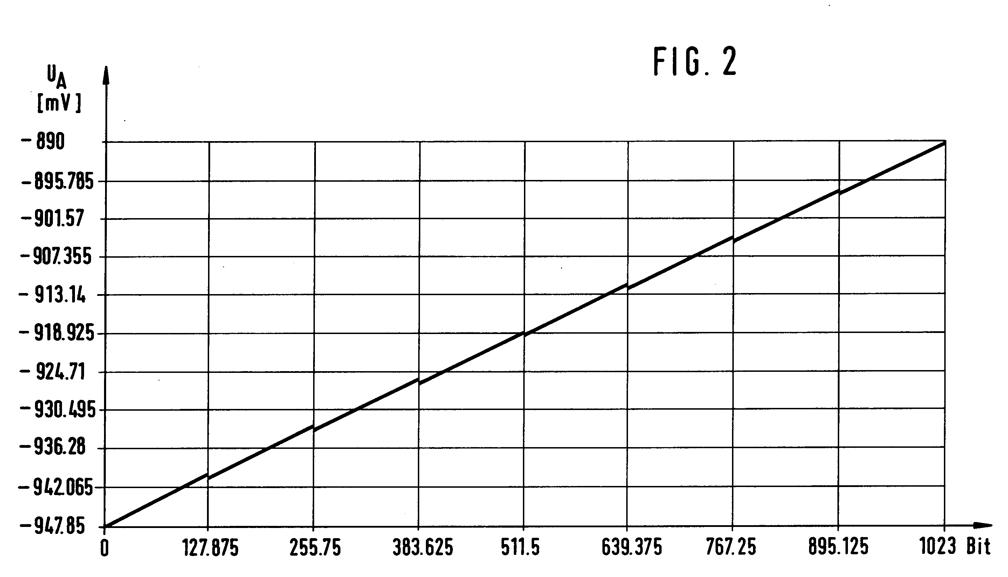

Fig. 2 zeigt eine solche Übertragungskennlinie eines D/A-Wandlers, der nach Abgleich nur noch negative differentielle Unstetigkeiten U1, U2, ... Un aufweist, die architekturbedingt beim Umschalten der gewichteten Konstantstromquellen Q1, Q2, ... Qn des D/A-Wandlers, wie aus Fig. 2 ersichtlich ist, bei folgenden Übergängen der Quantisierungsbereiche auftreten:
127 auf 128 Bit (127,875),
255 auf 256 Bit (255,75),
383 auf 384 Bit (383,625),
511 auf 512 Bit (511,5),
639 auf 640 Bit (639,375),
767 auf 768 Bit (767,25),
895 auf 896 Bit (895,125).

Sollte ein solcher D/A-Wandler von sich aus nur negative differentielle Unstetigkeiten aufweisen, erübrigt sich natürlich ein solcher Abgleich.

Fig. 6 zeigt die Amplitudenwerte der Unstetigkeiten U1, U2, ... Un (Differenzen der Major Carrys) für die unterschiedlichen Quantisierungsbereichsübergänge (Umschalten der toleranzbehafteten gewichteten Konstantstromquellen). Die gleichhohen links dargestellten positiven Amplitudenwerte beruhen nicht auf den Toleranzen der gewichteten Stromquellen, sondern stellen systematische Fehlerspannungen (Glitches) dar, die durch zusätzliche Maßnahmen vermindert werden können.

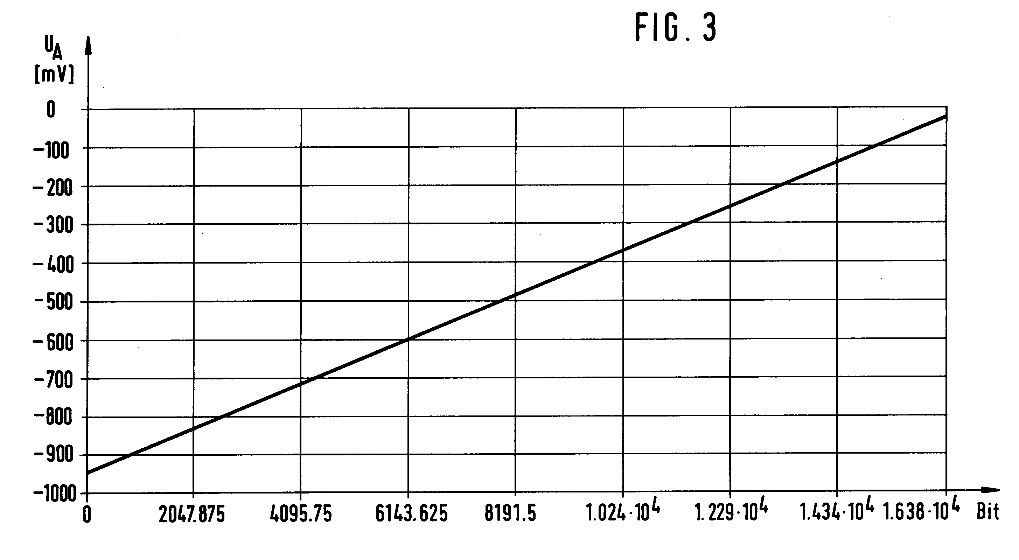

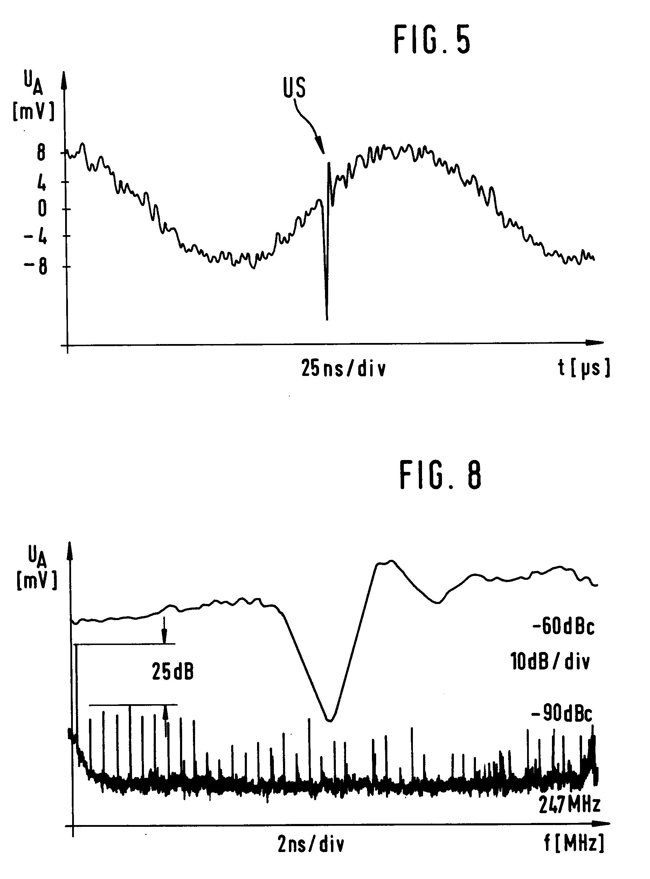

Die Amplitudenwerte der negativen differentiellen Unstetigkeiten U1, U2, ... Un werden dem Eingangssignal des D/A-Wandlers DAC1 an den Unstetigkeitsstellen mit dem inversen Vorzeichen zugesetzt. Durch diese Maßnehme nach der Erfindung läßt sich die in Fig. 3 dargestellte unstetigkeitsfreie linearisierte Übertragungskennlinie erreichen. Das Ausgangssignal des D/A-Wandlers ist nun bezüglich der Sinushalbwellen nicht mehr verschoben (Fig. 5). Was jedoch erhalten bleibt ist die systematische Fehlerspannung (Glitch), die erst durch zusätzliche Maßnahmen, wie noch gezeigt wird, verminderbar ist. Das zu Fig. 5 gehörige Signalspektrum ist in Fig. 8 dargestellt. Wie aus Fig. 8 ersichtlich, hat sich der Abstand der Oberwellenanteile zum Nutzsignal auf 25 dB vergrößert.

Zur Realisierung des Verfahrens nach der Erfindung eignet sich insbesondere ein Speicher S, der dem Eingang des D/A-Wandlers vorgeschaltet ist. In diesen Speicher S werden die ermittelten Amplituden der negativen differentiellen Unstetigkeiten U1, U2, ... Un oder davon abgeleitete Größen mit ihrem inversen Vorzeichen eingelesen. Die eingelesenen Werte müssen darüber hinaus gekennzeichnet werden, damit an der jeweils zugeordneten Unstetigkeitsstelle das Auslesen des entsprechenden Speicherinhaltes erfolgt und seine Weitergabe an den D/A-Wandler DAC1 veranlaßt wird. Im einfachsten Falle wird das Eingangssignal des D/A-Wandlers als Speicheradreßsignal verwendet oder in ein solches umgewandelt und damit das Auslesen der Speicherinhalte aktiviert. Zu diesem Zweck ist es vorteilhaft, den Speicher S mit einer Adreßsteuereinrichtung ADS auszustatten, die in Abhängigkeit der Quantisierung des zu wandelnden Eingangssignals die gespeicherten Werte zum D/A-Wandler weiterleitet. Es können auch den Wichtungskoeffizienten der Konstantstromquellen entsprechende Werte im Speicher S abgelegt werden. Werden die gespeicherten Werte nicht mit ihrem inversen Vorzeichen abgespeichert, so kann eine anschließende Subtraktion oder Vorzeicheninversion durchgeführt werden.

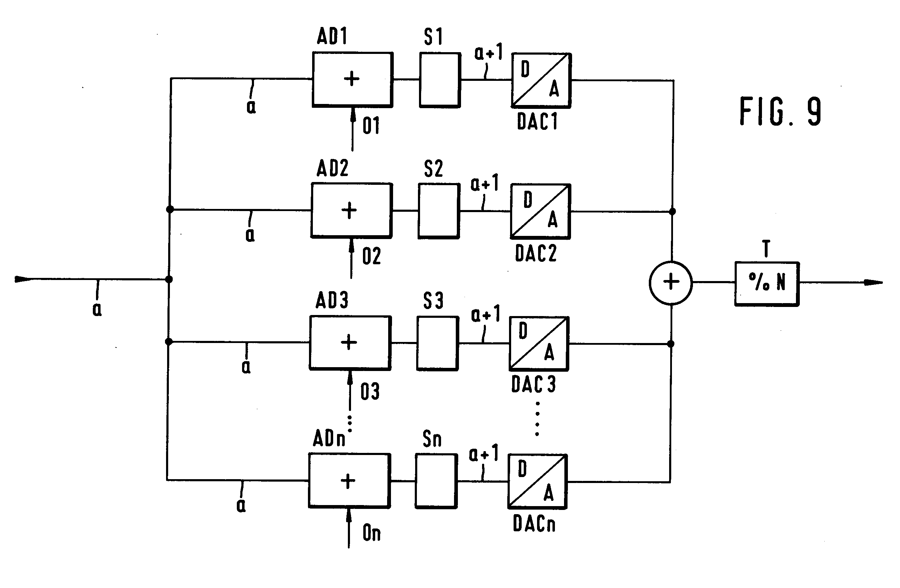

Zur Auflösungserhöhung eines D/A-Wandlers nach der Erfindung können mehrere D/A-Wandlerstufen parallel betrieben werden. Wie Fig. 9 zeigt, besteht ein solcher D/A-Wandler aus N vorzugsweise gleichartig aufgebauten D/A-Wandlerstufen DAC1, DAC2, DAC3, ... DACn, denen das zu wandelnde digitale Eingangssignal mit einer Wortbreite a von beispielsweise 12 Bit parallel und ohne Zwischenschaltung einer Selektionsstufe für einzelne Quantisierungsgruppen zugeführt wird. Jeder dieser D/A-Wandlerstufen DAC1, DAC2, DAC3, ... DACn ist eine Verknüpfungsstufe AD1, AD2, AD3, ... ADn zugeordnet, insbesondere vorgeschaltet zwischen jeweils einem Speicher S1, S2, ... Sn und jeweils einer D/A-Wandlerstufe DAC1, DAC2, ... DACn, die mit einem Offset 01, 02, 03, ... On, z.B. einem DC-Wert, beaufschlagt ist. Als Offsets können alternativ auch Wechselsignale mit definierten Spektrallinien oder pn-Sequenzen verwendet werden.

Diese Gleichspannungsoffset-Werte unterscheiden sich von Wandlerstufe zu Wandlerstufe voneinander. Sie sind insbesondere so gewählt (gleichverteilt), daß die Wahrscheinlichkeit für das Auftreten systematischer Fehlerspannungen, sogenannte Glitches, minimal wird. Die Verknüpfungsstufen AD1, AD2, AD3, ... ADn sind vorzugsweise als Addierer ausgebildet. Die Speicher S1, S2, ... Sn können auch so ausgebildet bzw. gesteuert sein, daß sie die Offsetwerte 01, 02, 03, ... On abgespeichert haben und jeweils mit den abgespeicherten differentiellen Unstetigkeiten U1, U2, ... Un verknüpfen. Bei dieser Alternative können separate Verknüpfungsstufen eingespart werden.

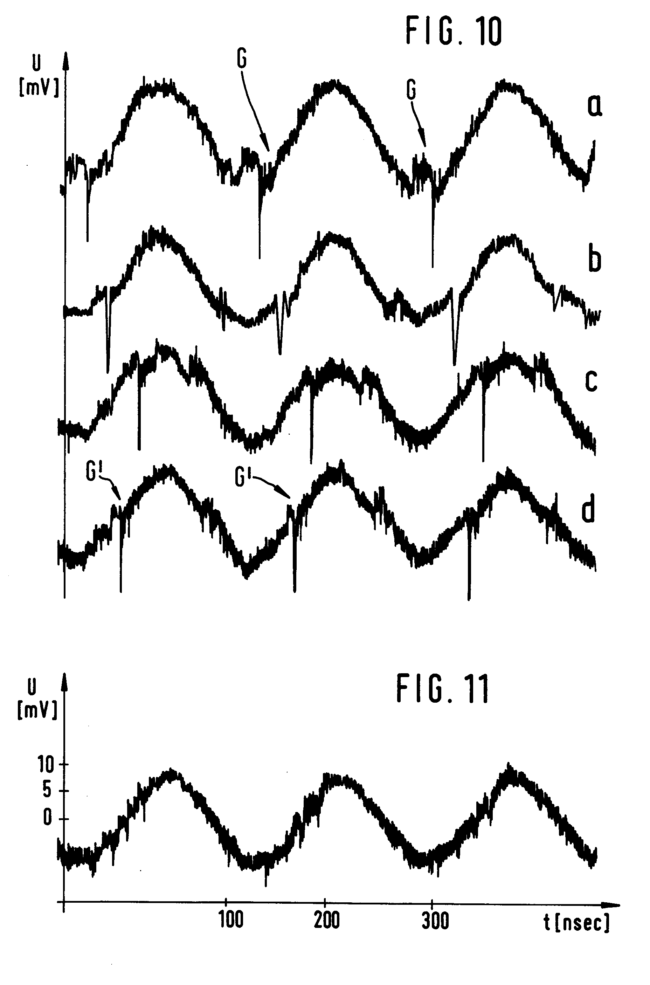

Die D/A-Wandlerstufen DAC1, DAC2, DAC3, ... DACn sind so ausgebildet, daß ihre zu verarbeitende Wortbreite a+1 um mindestens eine Bitposition größer ist als die Wortbreite a des D/A-Wandler-Eingangssignals. Alternativ zur Vergrößerung der Wortbreite kann auch der Aussteuerungsbereich geändert werden. Da die Glitches bedingt durch die Architektur der einzelnen D/A-Wandlerstufen typischerweise bei bestimmten Quantisierungsübergängen auftreten, werden die Gleichspannungsoffsetwerte gegeneinander variiert. Fig. 10 zeigt in den Zeilen a bis d ein digitalisiertes Sinussignal von 6 MHz mit einer Abtastfrequenz von 452 MHz und ± 8 LSB Aussteuerung, welches jeweils mit einem anderen Offsetwert 01, 02, 03, ... On beaufschlagt ist.

In Zeile a beträgt der Offsetwert O1 = 1031 Bit, in Zeile b: 02 = 1027 Bit, in Zeile c: 03 = 1019 Bit und in Zeile d: 04 = 1023 Bit.

Die N Ausgangssignale der D/A-Wandlerstufen DAC1, DAC2, DAC3, ... DACn werden vorzugsweise mittels eines Addierers ADD zusammengefaßt. Das Additionssignal wird anschließend mittels einem Teiler T bezüglich seiner Ausgangsspannungs- oder Ausgangsstromamplitude geteilt. Als Teilverhältnis eignet sich insbesondere die Zahl N (Anzahl der einzelnen D/A-Wandlerstufen).

Das Ausgangssignal des Teilers T, d.h. das Ausgangssignal des D/A-Wandlers ist in Fig. 11 dargestellt. Es ist durch die systematischen Fehlerspannungen der D/A-Wandlerstufen nur wenig verfälscht, da die Glitches G bzw. G' untereinander aufaddiert werden und ihre Amplitude um den Faktor N im Gesamtsignal abgesenkt ist.

Als systematische Fehler treten insbesondere auf:
- Gain- und Offsetfehler,
- Fehler der differentiellen und integralen Linearität,
- dynamische Fehler (Glitches, Spikes),
- kurzzeitige Spannungseinbrüche.

Alle vorgenannten Fehler werden durch die Maßnahmen der Erfindung in ihrer Auswirkung auf das D/A-Wandler-Ausgangssignals vermindert.

Allgemein läßt sich sagen, daß der Gewinn im S/N-Verhältnis um 3 dB je Verdopplung der Anzahl N der Wandlerstufen steigt.

Der D/A-Wandler nach der Erfindung eignet sich insbesondere zur Verarbeitung von digitalen Videosignalen oder Fernsehsignalen, die insbesondere zu Frequenzmultiplex-Kanalbündeln zusammengefaßt sind, wie z.B. bei den Verfahren gemäß DE 41 36 112 A1 oder DE 40 08 201 C2.

Der D/A-Wandler nach der Erfindung eignet sich auch für die direkte digitale Signalerzeugung (direct digital synthesis), beispielsweise für digitale Frequenzgeneratoren (VFOs) oder Radaranwendungen, z.B. zur Chirp-Aufbereitung.

## Patentansprüche

1. Verfahren zur Linearisierung von Unstetigkeiten in der Übertragungskennlinie mindestens eines D/A-Wandlers mit folgenden Schritten:
- Der D/A-Wandler wird gegebenenfalls so abgeglichen, daß sich nur noch im wesentlichen negative differentielle Unstetigkeiten (U1, U2, ... Un) in der Übertragungskennlinie ergeben,
- die Amplituden der negativen differentiellen Unstetigkeiten (U1, U2, ... Un) werden ermittelt und dem Eingangssignal des D/A-Wandlers an den Unstetigkeitsstellen mit dem inversen Vorzeichen zugesetzt.

2. Verfahren nach Anspruch 1, dadurch gekennzeichnet, daß die ermittelten Amplituden der negativen differentiellen Unstetigkeiten (U1, U2, ... Un) bzw. ihre inversen Werte in einen Speicher (S) eingelesen werden und daß das Auslesen des Speichers (S) und die Weitergabe der Speicherinhalte an den D/A-Wandler in Abhängigkeit des zu wandelnden Eingangssignal des D/A-Wandlers vorgenommen wird.

3. Verfahren nach Anspruch 2, dadurch gekennzeichnet, daß das zu wandelnde Eingangssignal in Abhängigkeit seiner Quantisierung als Speicheradreßsignal zum Auslesen der Speicherinhalte benutzt wird oder in ein solches Speicheradreßsignal umgewandelt wird.

4. Verfahren nach einem der Ansprüche 1 bis 3, dadurch gekennzeichnet, daß für einen D/A-Wandler, der gewichtete Konstantstromquellen (Q1, Q2, ... Qn) aufweist, die Wichtungskoeffizienten gegebenenfalls so nachgestellt werden, daß sich ausschließlich negative differentielle Unstetigkeiten (U1, U2, ... Un) in der Übertragungskennlinie ergeben und daß diese Wichtungskoeffizienten oder daraus abgeleitete Größen abgespeichert werden.

5. Verfahren nach einem der Ansprüche 1 bis 4, dadurch gekennzeichnet, daß die inversen Werte der negativen differentiellen Unstetigkeiten (U1, U2, ... Un) bzw. Wichtungskoeffizienten abgespeichert werden oder daß die differentiellen Unstetigkeiten (U1, U2, ... Un) bzw. Wichtungskoeffizienten mit positivem Vorzeichen abgespeichert werden und anschließend eine Subtraktion oder eine Vorzeicheninversion bezüglich der abgespeicherten Werte durchgeführt wird.

6. Verfahren nach einem der Ansprüche 1 bis 5, dadurch gekennzeichnet, daß mehrere D/A-Wandler parallel betrieben werden.

7. Verfahren nach Anspruch 6, dadurch gekennzeichnet, daß die parallel betriebenen D/A-Wandler mit jeweils unterschiedlichen Offsets (01, 02, 03, ... On) beaufschlagt werden.

8. Verfahren nach Anspruch 7, dadurch gekennzeichnet, daß die Offsets (01, 02, 03, ... On), insbesondere Gleichspannungsoffsets, so gewählt werden, daß die Wahrscheinlichkeit für das Auftreten systematischer Fehlerspannungen ("Glitches") minimal ist.

9. Anordnung zur Linearisierung von Unstetigkeiten in der Übertragungskennlinie mindestens eines D/A-Wandlers mit folgenden Merkmalen:
- einem Speicher (S), welcher einem D/A-Wandler (DAC1) vorgeschaltet ist und welcher als Speicherinhalte nur Werte der negativen differentiellen Unstetigkeiten (U1, U2, U3, ... Un) in der Übertragungskennlinie des D/A-Wandlers / der D/A-Wandler (DAC1, DAC2, DAC3, ... DACn) oder davon abgeleiteter Größen enthält.

10. Anordnung nach Anspruch 9, dadurch gekennzeichnet, daß eine Adreßsteuereinrichtung (ADS) für den Speicher (S) vorgesehen ist, die in Abhängigkeit der Quantisierung des zu wandelnden Eingangssignals des/der D/A-Wandler/s (DAC1, DAC2, DAC3, ... DACn) die gespeicherten Werte zum / zu den DA-Wandler/n (DAC1, DAC2, DAC3, ... DACn) weiterleitet.

11. Anordnung nach einem der Ansprüche 9 oder 10, dadurch gekennzeichnet, daß mehrere D/A-Wandler (DAC1, DAC2, DAC3, ... DACn) parallel betrieben sind, denen jeweils eine Verknüpfungsstufe, insbesondere ein Addierer (AD1, AD2, AD3, ... ADn), zur Beaufschlagung der D/A-Wandler-Eingangssignale mit jeweils unterschiedlichen Offsets (01, 02, 03, ...On) sowie ein Speicher (S1, S2, S3, ... Sn) für die differentiellen Unstetigkeiten (U1, U2, U3, ... Un) vorgeschaltet ist.

12. Anordnung nach einem der Ansprüche 9 oder 10, dadurch gekennzeichnet, daß mehrere D/A-Wandler (DAC1, DAC2, ... DACn) parallel betrieben sind, denen jeweils ein Speicher (S1, S2, S3, ... Sn) vorgeschaltet ist, wobei diese Speicher bzw. deren Speicherinhalt so ausgebildet ist, daß die D/A-Wandler-Eingangssignale sowohl mit jeweils unterschiedlichen Offsets (01, 02, 03, ... On) als auch mit den negativen differentiellen Unstetigkeiten (U1, Us, U3, ... Un) beaufschlagt sind.

13. Anwendung des Verfahrens nach einem der Ansprüche 1 bis 8 oder der Anordnung nach einem der Ansprüche 9 bis 12 für ein digitales Videosignal bzw. Fernsehsignal, insbesondere für ein daraus zusammengesetzes Frequenzmultiplex-Kanal-Bündel.
